# EUROPEAN PATENT APPLICATION

(11) **EP 4 407 868 A1**
(43) Date of publication of application: **31.07.2024**
(21) Application number: 24150519.7
(22) Date of filing: 05.01.2024
(51) Int. Cl.: H03H 3/02, H03H 9/19

(54) **CRYSTAL OSCILLATOR AND METHOD FOR MAKING THE SAME**

(30) Priority: 07.01.2023 TW 112100761
(71) Applicant: Aker Technoology Co., Ltd., Taichung City 42760 (TW)
(72) Inventor: HORNG, Ray-Hua, 40253 Taichung City (TW); LIN, Yi-Lun, 42760 Taichung City (TW)
(74) Representative: V.O.

(57) **Abstract**

A crystal oscillator includes an oscillating main body (2), a top electrode layer (3), a bottom electrode layer (4), and a magnetic layer (5). The oscillating main body (2) includes a thinned portion (21) and a side portion (22). The thinned portion (21) has upper and lower surfaces (211, 212) respectively defining upper and lower surface work portions (2111, 2121). The side portion (22) is connected to one end of the thinned portion (21). The top electrode layer (3) is disposed on the upper surface (211), and includes a top work portion (31) disposed on the upper surface work portion (2111). The bottom electrode layer (4) is disposed on the lower surface (212), and includes a bottom work portion (41) disposed on the lower surface work portion (2121). The magnetic layer (5) is disposed on the side portion (22), and is spaced apart from the top electrode layer (3).

## Description

The disclosure relates to a crystal oscillator, and more particularly to a quartz crystal oscillator. The disclosure also relates to a method for making the crystal oscillator.

A quartz crystal oscillator is a device that utilizes a piezoelectric effect of a quartz crystal to generate an oscillating frequency. The quartz crystal oscillator is often used in various electronic products (for example, a communication equipment). A conventional quartz crystal oscillator generally includes a quartz substrate, and a top electrode and a bottom electrode respectively disposed on a top surface and a bottom surface of the quartz substrate. The bottom electrode extends from the bottom surface of the quartz substrate toward a periphery of the quartz substrate. In order to facilitate external electrical connection, the top electrode and the bottom electrode of the quartz crystal oscillator are desirably located on a same surface of the quartz substrate. It is known that if the quartz substrate has a reduced thickness, the quartz crystal oscillator can generate a higher oscillation frequency. Therefore, by reducing the thickness of the quartz substrate, a predetermined high oscillation frequency of the quartz crystal oscillator can be attained, which is conducive for application in the field of high frequency communication.

As shown in FIGS. 1 and 2, Japanese Invention Patent Application Publication No. JP6079280B2 discloses an oscillation device 1, which includes an oscillating main body 11, a top excitation electrode 12 and a bottom excitation electrode 13. The oscillating main body 11 includes a thinned portion 111 having an upper surface 1111 and a lower surface 1112, and a thick portion 112 partially surrounding the thinned portion 111 and having a thickness that is greater than a thickness of the thinned portion 111. The top excitation electrode 12 includes a top work portion 121 disposed on the upper surface 1111 of the thinned portion 111, a top extending portion 122 extending from the top work portion 121 toward the thick portion 112, and a top pad portion 123 connected to the top extending portion 122. The bottom excitation electrode 13 includes a bottom work portion 131 disposed on the lower surface 1112 of the thinned portion 111, a bottom extending portion 132 extending from the bottom work portion 131 toward the thick portion 112, and a bottom pad portion 133 connected to the bottom extending portion 132.

With the provision of the thinned portion 111 of the oscillating main body 11 which permits the top work portion 121 and the bottom work portion 131 to be disposed thereon, the oscillation device 1 can be used in a communication electronic product (not shown) that has a high oscillation frequency. However, because the top excitation electrode 12 and the bottom excitation electrode 13 of the oscillation device 1 are not located on a same surface of the thinned portion 111 of the oscillating main body 11, a bonding wire is required to electrically connect the top pad portion 123 of the top excitation electrode 12 and a circuit board of a communication electronic product when the oscillation device 1 is intended to be electrically connected to the circuit board of the communication electronic product, which may require an additional step in a manufacturing process of the oscillation device 1.

It is noted that the top excitation electrode 12 may be formed using a combination of a photolithography technique and a thin film deposition technique or a combination of a metal mask and the thin film deposition technique. Because the thinned portion 111 of the oscillating main body 11 is extremely thin, the thinned portion 111 may be easily damaged during photolithography process when the top excitation electrode 12 is formed using the photolithography technique and the thin film deposition technique. On the other hand, when the top excitation electrode 12 is formed using the metal mask and the thin film deposition technique, an opening of the metal mask may not be in positional correspondence with a position of the top excitation electrode 12 to be formed on the oscillating main body 11 due to the metal mask (not shown) being distal from the oscillating main body 11 (because the thickness of the thick portion 112 is greater than the thickness of the thinned portion 111). A size precision of the top excitation electrode 12 formed by the thin film deposition may be decreased accordingly. In addition, when the oscillation device 1 is applied in the communication electronic product, the oscillation device 1 is transferred to a circuit board of the communication electronic product only by using a robotic arm to pick the thick portion 112 of the oscillating main body 11.

In view of above, there is a need to improve a structure of the quartz crystal oscillator and a method for making the same, so that the quartz crystal oscillator may be transferred onto the circuit board of the communication electronic product through other ways besides the robotic arm, and so that a decreased size precision of the top excitation electrode 12 can be avoided.

Therefore, an object of the disclosure is to provide a crystal oscillator and a method for making the same, that can alleviate at least one of the drawbacks of the prior art.

According to a first aspect of the disclosure, there is provided a crystal oscillator according to claim 1.

According to a second aspect of the disclosure, there is provided a method for making a crystal oscillator according to claim 6.

Other features and advantages of the disclosure will become apparent in the following detailed description of the embodiment(s) with reference to the accompanying drawings. It is noted that various features may not be drawn to scale.

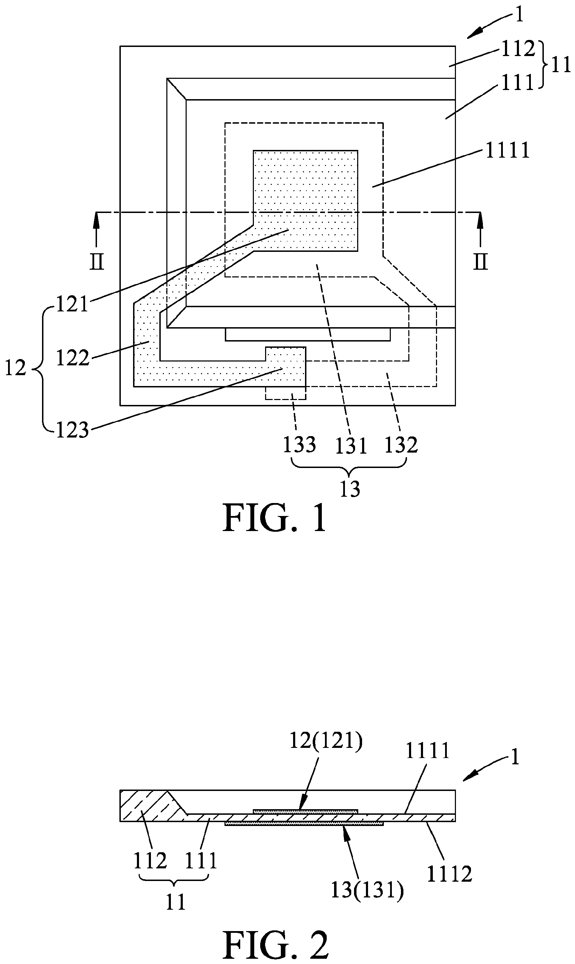

FIG. 1 is a schematic top view illustrating a conventional oscillating device.
FIG. 2 is a cross-sectional view taken along line II-II of FIG. 1.
FIG. 3 is a flow chart illustrating consecutive steps of a method for making an embodiment of a crystal oscillator according to the disclosure.
FIGS. 4 to 17 are schematic views illustrating some intermediate stages of the method as depicted in FIG. 3.
FIG. 18 is a schematic perspective view illustrating the embodiment of the crystal oscillator according to the disclosure.

Before the disclosure is described in greater detail, it should be noted that where considered appropriate, reference numerals or terminal portions of reference numerals have been repeated among the figures to indicate corresponding or analogous elements, which may optionally have similar characteristics.

It should be noted herein that for clarity of description, spatially relative terms such as "top," "bottom," "upper," "lower," "on," "upwardly," "downwardly" and the like may be used throughout the disclosure while making reference to the features as illustrated in the drawings. The features may be oriented differently (e.g., rotated 90 degrees or at other orientations) and the spatially relative terms used herein may be interpreted accordingly.

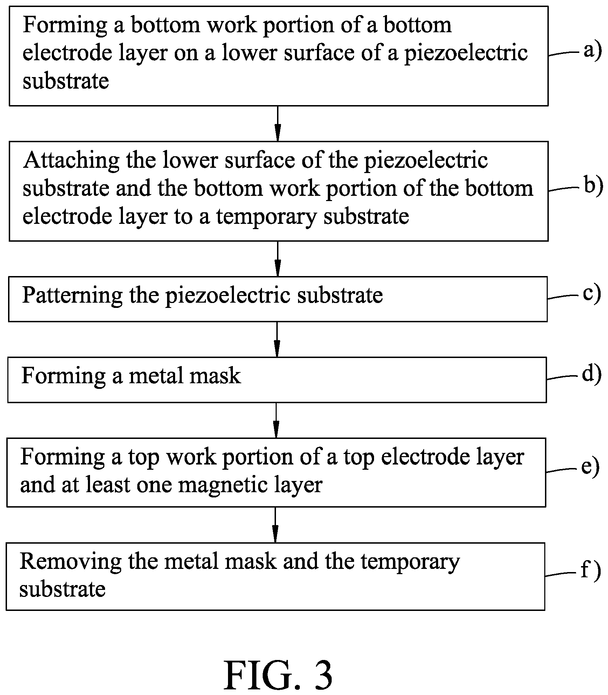

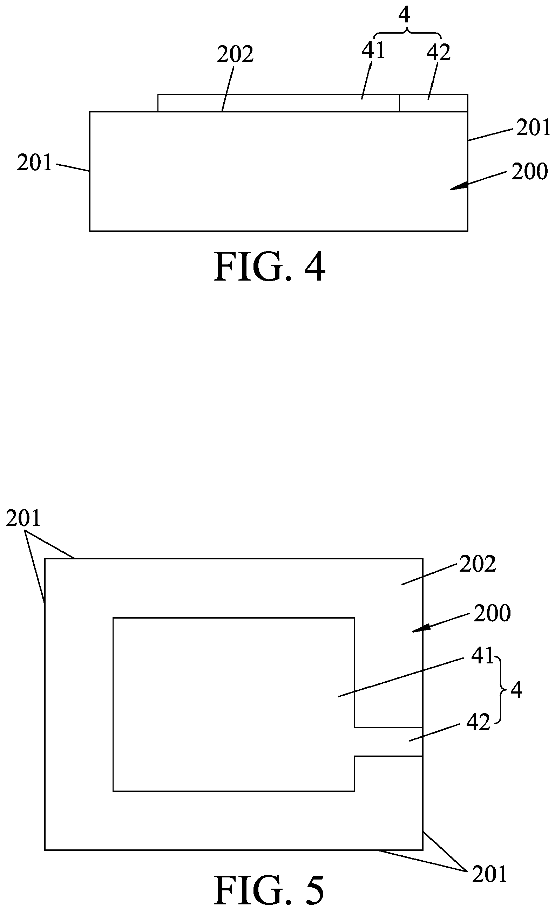

Referring to FIG. 3, a method for making an embodiment of a crystal oscillator according to the disclosure includes the following consecutive steps a) to f). FIGS. 4 to 17 illustrate intermediate stages of the method for making the embodiment of the crystal oscillator.

Referring to FIGS. 4 and 5, in step a), a bottom work portion 41 of a bottom electrode layer 4 is formed on a lower surface 202 of a piezoelectric substrate 200. The bottom work portion 41 of the bottom electrode layer 4 is spaced apart from a plurality of peripheral surfaces 201 of the piezoelectric substrate 200. FIG. 5 is a schematic top view of the piezoelectric substrate 200 shown in FIG. 4. In this embodiment, the piezoelectric substrate 200 is a quartz substrate.

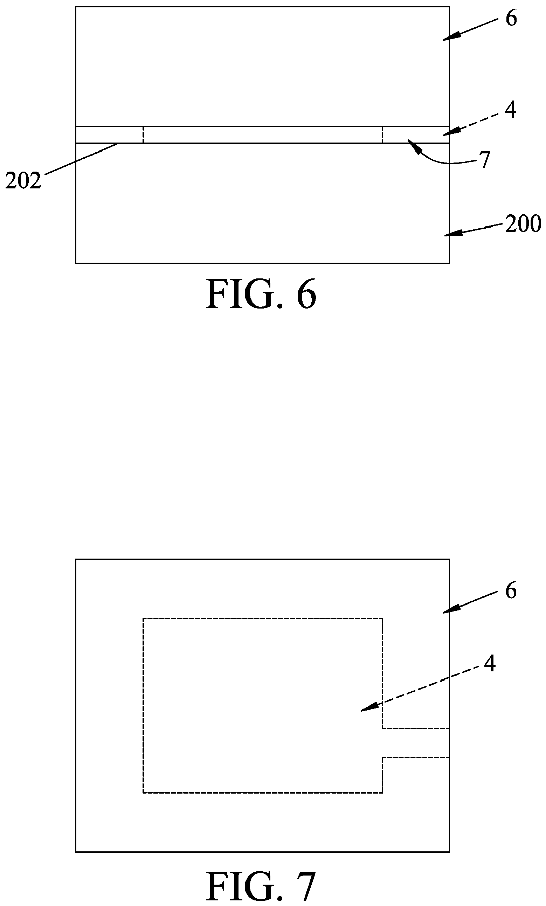

Referring to FIGS. 6 and 7, in step b), the lower surface 202 of the piezoelectric substrate 200 and the bottom work portion 41 of the bottom electrode layer 4 are attached to a temporary substrate 6. Specifically, step b) may be performed using a wax 7, a photolytic adhesive material, or a pyrolysis adhesive material to allow the lower surface 202 of the piezoelectric substrate 200 and the bottom work portion 41 of the bottom electrode layer 4 to be attached to the temporary substrate 6. In this embodiment, the lower surface 202 of the piezoelectric substrate 200 and the bottom work portion 41 of the bottom electrode layer 4 are attached to the temporary substrate 6 using the wax 7.

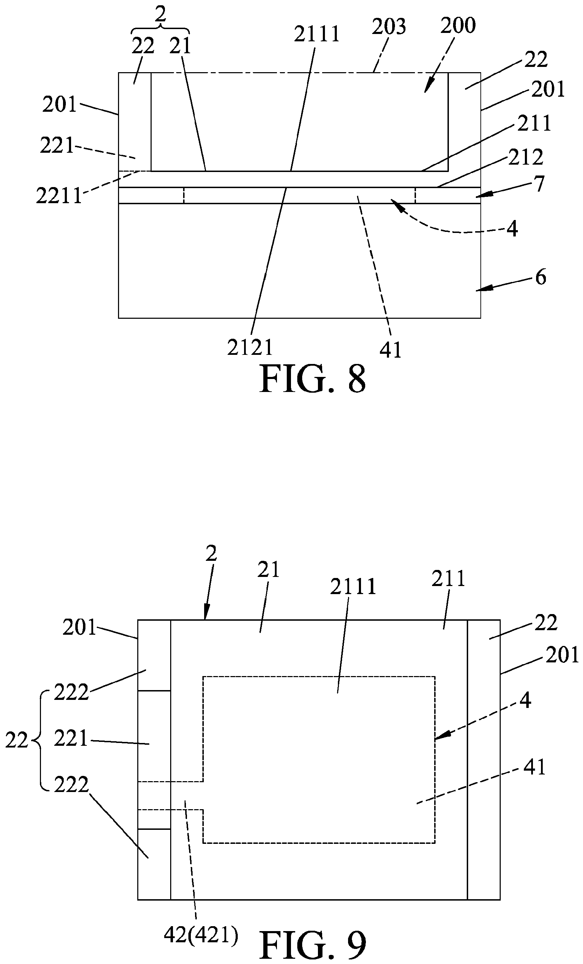

Referring to FIGS. 8 and 9, in step c), a patterning process is performed to pattern the piezoelectric substrate 200 from an upper surface 203 thereof opposite to the lower surface 202 thereof, so as to form the piezoelectric substrate 200 into an oscillating main body 2 including a thinned portion 21 and at least one side portion 22. The thinned portion 21 has an upper surface 211 and a lower surface 212 which are opposite to each other and which respectively define an upper surface work portion 2111 and a lower surface work portion 2121 that are spaced apart from the peripheral surfaces 201. The bottom work portion 41 of the bottom electrode layer 4 is formed on the lower surface work portion 2121. The at least one side portion 22 is connected to at least one end of the thinned portion 21, and extends upwardly in a direction from the lower surface 212 to the upper surface 211.

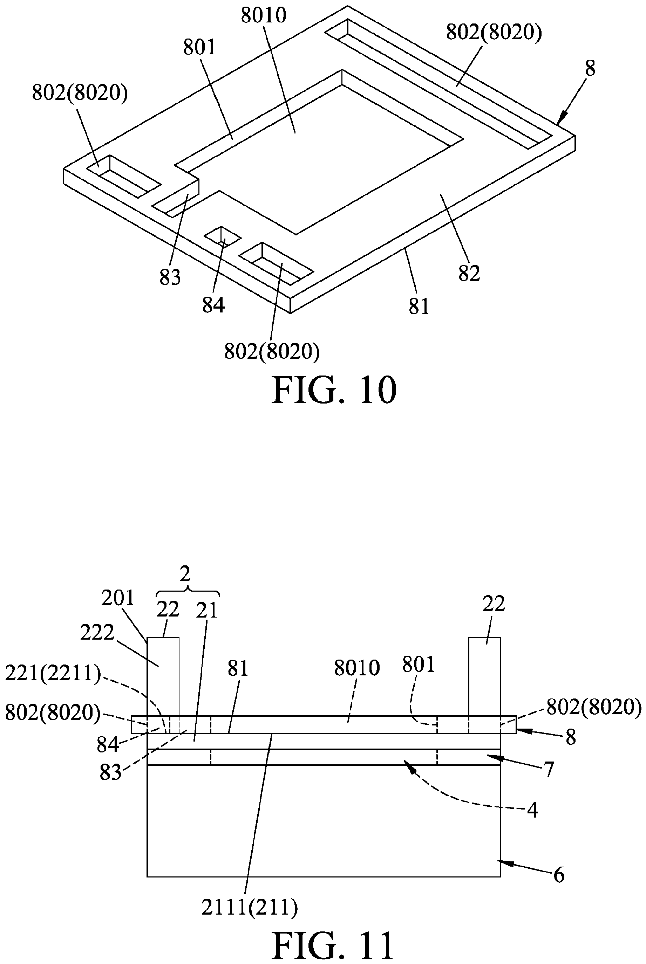

Referring to FIGS. 10 and 11, in step d), a metal mask 8 is disposed on the oscillating main body 2. The metal mask 8 has a first opening 8010, at least one second opening 8020, and a lower surface 81. The first opening 8010 and the at least one second opening 8020 penetrate the metal mask 8, are spaced apart from each other, and are respectively defined by a first opening-defining wall 801 and at least one second opening-defining wall 802. The upper surface work portion 2111 of the thinned portion 21 is exposed from the first opening 8010. The at least one side portion 22 extends through the at least one second opening 8020. The lower surface 81 of the metal mask 8 faces the upper surface 211 of the thinned portion 21. A distance between the lower surface 81 of the metal mask 8 and the upper surface 211 of the thinned portion 21 is less than a distance between the upper surface 211 of the thinned portion 21 and a top surface of the at least one side portion 22.

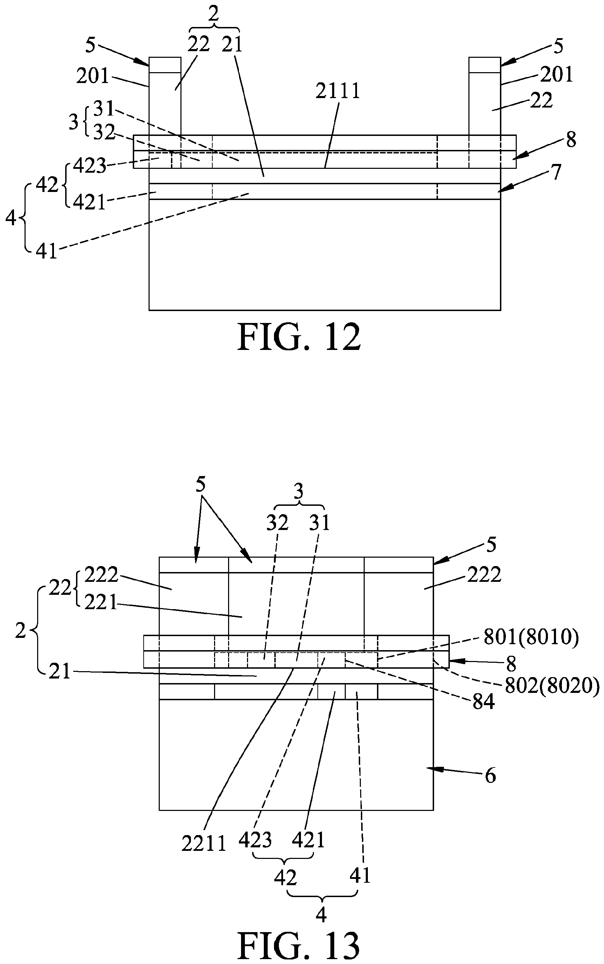

Referring to FIGS. 12 and 13, in step e), a top work portion 31 of a top electrode layer 3 is formed on the upper surface work portion 2111 of the thinned portion 21, and at least one magnetic layer 5 is formed on the at least one side portion 22. The top work portion 31 of the top electrode layer 3 and the at least one magnetic layer 5 are spaced apart from each other.

In certain embodiments, in step c), the at least one side portion 22 includes two side portions 22 respectively connected to two opposite ends of the thinned portion 21 (see FIG. 9). One of the two side portions 22 (see the left one of the two side portions 22 in FIGS. 8 and 9) includes two protruding parts 222 separated from each other by a recess 221 that is recessed downwardly from an upper surface of the one of the two side portions 22. The upper surface 211 of the thinned portion 21 and a bottom surface of the recess 221 are flush with each other. Specifically, step c) includes the sub-steps of: (i) forming a mask layer (not shown) having a predetermined pattern on the piezoelectric substrate 200, and (ii) removing a portion of the piezoelectric substrate 200 not covered by the mask layer using a wet etching or a dry etching, so that the piezoelectric substrate 200 is formed into the oscillating main body 2 including the thinned portion 21 and the two side portions 22, and so that the one of the two side portions 22 (see the left one of the two side portions 22 in FIG. 9) is formed with the protruding parts 222 and the recess 221.

In certain embodiments, in step d) (see FIGS. 10 and 11), the at least one second opening 8020 includes three second openings 8020, and the metal mask 8 further has a first through hole 83 penetrating the metal mask 8 from an upper surface 82 of the metal mask 8 opposite to the lower surface 81 to the lower surface 81 of the metal mask 8. Specifically, the first through hole 83 is in spatial communication with the first opening 8010 and extends from the first opening 8010 to a corresponding one of the peripheral surfaces 201 of the oscillating main body 2 to which the recess 221 is adjacent. The two protruding parts 222 of the one of the two side portions 22 respectively extend through two corresponding ones of the second openings 8020 (also see FIG. 13), and the other one of the two side portions 22 extends through a remaining one of the second openings 8020 (the right one of the second openings 8020 in FIG. 10). In certain embodiments, in step e) (see FIGS. 12 and 13), a top extending portion 32 of the top electrode layer 3 is formed in the first through hole 83 and extends from the top work portion 31 to the corresponding one of the peripheral surfaces 201 of the oscillating main body 2 to which the recess 221 is adjacent, and at least one magnetic layer 5 includes three magnetic layers 5 formed on the two protruding parts 222 of the one of the two side portions 22 and the other one of the two side portions 22, respectively.

In certain embodiments, in step a) (see FIG. 9), a lower section 421 of a bottom extending portion 42 of the bottom electrode layer 4 is further formed to extend from the bottom work portion 41 to the corresponding one of the peripheral surfaces 201 of the oscillating main body 2 to which the recess 221 is adjacent, in step d) (see FIGS. 10 and 11), the metal mask 8 further has a second through hole 84 which penetrates the metal mask 8 from the upper surface 82 of the metal mask 8 to the lower surface 81 of the metal mask 8, which is spaced apart from the first through hole 83, which extends to the corresponding one of the peripheral surfaces 201 of the oscillating main body 2 to which the recess 221 is adjacent, and which exposes the bottom surface 2211 of the recess 221, and in step e) (see FIGS. 12 and 13), an upper section 423 of the bottom extending portion 42 is further formed on the bottom surface 2211 of the recess 221.

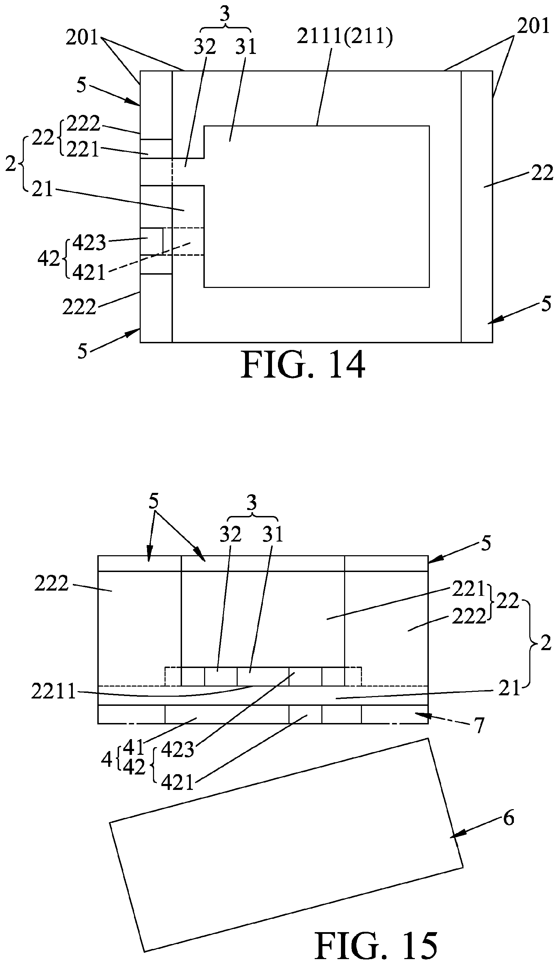

Referring to FIGS. 14 and 15, in step f), the metal mask 8 (see FIG. 13) is removed to expose the upper section 423 of the bottom extending portion 42 of the bottom electrode layer 4, and the temporary substrate 6 is removed to expose the bottom work portion 41 of the bottom electrode layer 4. Specifically, in this step, the temporary substrate 6 is removed from the oscillating main body 2 and the bottom electrode layer 4 by melting the wax 7 at a temperature higher than a melting point of the wax 7. It is noted that, when a photolytic adhesive material or a pyrolysis adhesive material is used to attach the lower surface 202 of the piezoelectric substrate 200 and the bottom electrode layer 4 to the temporary substrate 6 in step b), the temporary substrate 6 may be removed from the oscillating main body 2 and the bottom electrode layer 4 by a photo treatment or a thermal treatment.

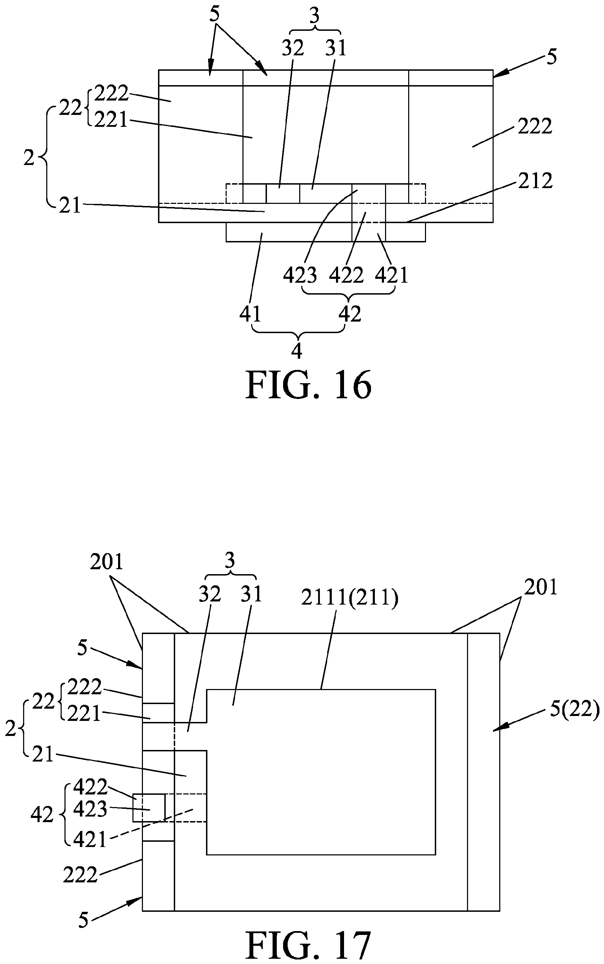

Referring to FIGS. 16 and 17, in certain embodiments, after step e) or step f), an interconnecting section 422 of the bottom extending portion 42 of the bottom electrode layer 4 is formed on the corresponding one of the peripheral surfaces 201 of the oscillating main body 2 to interconnect the lower section 421 and the upper section 423 of the bottom extending portion 42 of the bottom electrode layer 4. In such case, formation of the interconnecting section 422 may involve disposing a silver paste on the corresponding one of the peripheral surfaces 201 of the oscillating main body 2 using a robotic arm (not shown), so as to form the interconnecting section 422.

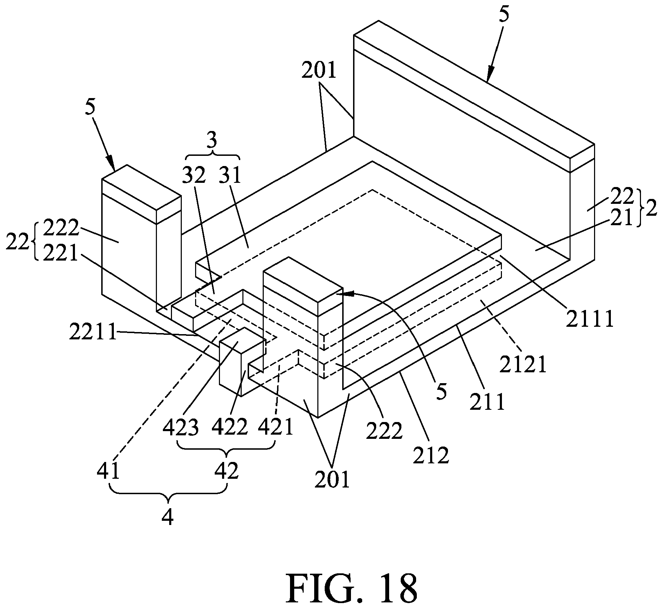

FIG. 18 illustrates the embodiment of the crystal oscillator according to the disclosure, which includes the oscillating main body 2, the top electrode layer 3, the bottom electrode layer 4, and the three magnetic layers 5.

The oscillating main body 2 includes the thinned portion 21 and the two side portions 22. The thinned portion 21 has the upper surface 211 and the lower surface 212 which are opposite to each other and which respectively define the upper surface work portion 2111 and the lower surface work portion 2121 that are spaced apart from the peripheral surfaces 201 of the oscillating main body 2. The two side portions 22 are connected to the two opposite ends of the thinned portion 21, and extend upwardly in the direction from the lower surface 212 to the upper surface 211. One of the two side portions 22 (the left one of the two side portions 22 in FIG. 18) includes the two protruding parts 222 separated from each other by the recess 221 that is recessed downwardly from the upper surface of the one of the two side portions 22. The upper surface 211 of the thinned portion 21 and the bottom surface 2211 of the recess 221 are flush with each other.

The top electrode layer 3 includes the top work portion 31 disposed on the upper surface work portion 2111 of the thinned portion 21, and the top extending portion 32 extending from the top work portion 31 to the corresponding one of the peripheral surfaces 201 of the oscillating main body 2 to which the recess 221 is adjacent.

The bottom electrode layer 4 includes the bottom work portion 41 disposed on the lower surface work portion 2121 of the thinned portion 21, and the bottom extending portion 42 which includes the lower section 421, the interconnecting section 422, and the upper section 423. The lower section 421 of the bottom extending portion 42 of the bottom electrode layer 4 extends from the bottom work portion 41 to the corresponding one of the peripheral surfaces 201 of the oscillating main body 2 to which the recess 221 is adjacent. The upper section 423 of the bottom extending portion 42 of the bottom electrode layer 4 is disposed on the bottom surface 2211 of the recess 221, and is spaced apart from the top extending portion 32 of the top electrode layer 3. The interconnecting section 422 of the bottom extending portion 42 of the bottom electrode layer 4 is disposed on the corresponding one of the peripheral surfaces 201 of the oscillating main body 2 to which the recess 221 is adjacent, and is connected to the lower section 421 and the upper section 423 of the bottom extending portion 42 of the bottom electrode layer 4.

The three magnetic layers 5 are respectively disposed on the two protruding parts 222 of the one of the two side portions 22 and the other one of the two side portions 22, and are spaced apart from the top electrode layer 3. In this embodiment, the top electrode layer 3 and the three magnetic layers 5 are made of nickel (Ni).

As shown in FIGS. 10 and 11, in step d) of the method for making the embodiment of the crystal oscillator according to the disclosure, the two protruding parts 222 of the one of the two side portions 22 respectively extend through the two corresponding ones of the second openings 8020 (also see FIG. 13), the other one of the two side portions 22 extends through the remaining one of the second openings 8020 (the right one of the second openings 8020 in FIG. 10), and the distance between the lower surface 81 of the metal mask 8 and the upper surface 211 of the thinned portion 21 is less than a distance between the upper surface 211 of the thinned portion 21 and the top surfaces of the side portions 22, such that the lower surface 81 of the metal mask 8 is proximate to the upper surface 211 of the thinned portion 21 of the oscillating main body 2. Therefore, in step e), a size precision of each of the top work portion 31, the top extending portion 32, and the upper section 423 of the bottom extending portion 42 formed in step e) can be increased.

In addition, the top electrode layer 3, the upper section 423 of the bottom extending portion 42 of the bottom electrode layer 4, and the magnetic layers 5 formed in step e) are spaced apart from each other, so that when the crystal oscillator is applied in a communication electronic product, a device having a magnetic force (for example, a device with an electromagnetic adsorption head) can be utilized to adsorb the magnetic layers 5, for example, using an inductive current, such that the magnetic layers 5 are adsorbed by the electromagnetic adsorption head, so as to transfer the crystal oscillator to a circuit board of the communication electronic product without using the robotic arm.

In the crystal oscillator of this disclosure, due to the lower surface 81 of the metal mask 8 being proximate to the upper surface 211 of the thinned portion 21 of the oscillating main body 2, the size precision of each of the top work portion 31, the top extending portion 32, and the upper section 423 of the bottom extending portion 42 thus formed may be increased. In addition, the crystal oscillator may be transferred to a communication electronic product in a manner that the magnetic layers 5 are directly adsorbed by a device having a magnetic force.

In the description above, for the purposes of explanation, numerous specific details have been set forth in order to provide a thorough understanding of the embodiment(s). It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects; such does not mean that every one of these features needs to be practiced with the presence of all the other features. In other words, in any described embodiment, when implementation of one or more features or specific details does not affect implementation of another one or more features or specific details, said one or more features may be singled out and practiced alone without said another one or more features or specific details. It should be further noted that one or more features or specific details from one embodiment may be practiced together with one or more features or specific details from another embodiment, where appropriate, in the practice of the disclosure.

## Claims

1. A crystal oscillator, **characterized by**:
an oscillating main body (2) including a thinned portion (21) and at least one side portion (22), said thinned portion (21) having an upper surface (211) and a lower surface (212) opposite to each other and respectively defining an upper surface work portion (2111) and a lower surface work portion (2121) which are spaced apart from a plurality of peripheral surfaces (201) of said oscillating main body (2), said at least one side portion (22) being connected to at least one end of said thinned portion (21), and extending upwardly in a direction from said lower surface (212) to said upper surface (211);
a top electrode layer (3) disposed on said upper surface (211) of said thinned portion (21), and including a top work portion (31) disposed on said upper surface work portion (2111) of said thinned portion (21);
a bottom electrode layer (4) disposed on said lower surface (212) of said thinned portion (21), and including a bottom work portion (41) disposed on said lower surface work portion (2121) of said thinned portion (21); and
at least one magnetic layer (5) disposed on said at least one side portion (22), and spaced apart from said top electrode layer (3).

2. The crystal oscillator as claimed in claim 1, wherein said at least one side portion (22) includes two side portions (22) respectively connected to two opposite ends of said thinned portion (21), one of said two side portions (22) including two protruding parts (222) separated from each other by a recess (221) recessed downwardly from an upper surface of said one of said two side portions (22), said upper surface (211) of said thinned portion (21) and a bottom surface (2211) of said recess (221) being flush with each other.

3. The crystal oscillator as claimed in claim 2, wherein said top electrode layer (3) further includes a top extending portion (32) extending from said top work portion (31) to a corresponding one of said peripheral surfaces (201) of said oscillating main body (2) to which said recess (221) is adjacent.

4. The crystal oscillator as claimed in claim 2, wherein said at least one magnetic layer (5) includes three magnetic layers (5) respectively disposed on said two protruding parts (222) and the other one of said two side portions (22).

5. The crystal oscillator as claimed in claim 3, wherein said bottom electrode layer (4) further includes a bottom extending portion (42) which includes a lower section (421), an interconnecting section (422), and an upper section (423), said lower section (421) extending from said bottom work portion (41) to said corresponding one of said peripheral surfaces (201) of said oscillating main body (2) to which said recess (221) is adjacent, said upper section (423) being disposed on said bottom surface (2211) of said recess (221) and being spaced apart from said top extending portion (32) of said top electrode layer (3), said interconnecting section (422) being disposed on said corresponding one of said peripheral surfaces (201) of said oscillating main body (2) to which said recess (221) is adjacent and being connected to said lower section (421) and said upper section (423).

6. A method for making a crystal oscillator, **characterized by** the steps of:
a) forming a bottom work portion (41) of a bottom electrode layer (4) on a lower surface (202) of a piezoelectric substrate (200), such that the bottom work portion (41) of the bottom electrode layer (4) is spaced apart from a plurality of peripheral surfaces (201) of the piezoelectric substrate (200);
b) attaching the lower surface (202) of the piezoelectric substrate (200) and the bottom work portion (41) of the bottom electrode layer (4) to a temporary substrate (6);
c) patterning the piezoelectric substrate (200) from an upper surface (203) of the piezoelectric substrate (200) opposite to the lower surface (202) of the piezoelectric substrate (200), so as to form the piezoelectric substrate (200) into an oscillating main body (2) including a thinned portion (21) and at least one side portion (22), the thinned portion (21) having an upper surface (211) and a lower surface (212) which are opposite to each other and which respectively define an upper surface work portion (2111) and a lower surface work portion (2121) that are spaced apart from the peripheral surfaces (201), the at least one side portion (22) being connected to at least one end of the thinned portion (21), and extending upwardly in a direction from the lower surface (212) to the upper surface (211);
d) disposing a metal mask (8) on the oscillating main body (2), the metal mask (8) having a first opening (8010), at least one second opening (8020), and a lower surface (81), the first opening (8010) and the at least one second opening (8020) penetrating the metal mask (8), being spaced apart from each other, and being respectively defined by a first opening-defining wall (801) and at least one second opening-defining wall (802), the upper surface work portion (2111) of the thinned portion (21) being exposed from the first opening (8010), the at least one side portion (22) extending through the at least one second opening (8020), the lower surface (81) of the metal mask (8) facing the upper surface (211) of the thinned portion (21), and a distance between the lower surface (81) of the metal mask (8) and the upper surface (211) of the thinned portion (21) being less than a distance between the upper surface (211) of the thinned portion (21) and a top surface of the at least one side portion (22);
e) forming a top work portion (31) of a top electrode layer (3) on the upper surface work portion (2111) of the thinned portion (21), and forming at least one magnetic layer (5) on the at least one side portion (22), the top work portion (31) of the top electrode layer (3) and the at least one magnetic layer (5) being spaced apart from each other; and
f) removing the temporary substrate (6) to expose the bottom work portion (41) of the bottom electrode layer (4).

7. The method as claimed in claim 6, wherein
in step c), the at least one side portion (22) includes two side portions (22) respectively connected to two opposite ends of the thinned portion (21), one of the two side portions (22) including two protruding parts (222) separated from each other by a recess (221) that is recessed downwardly from an upper surface of the one of the two side portions (22), the upper surface (211) of the thinned portion (21) and a bottom surface (2211) of the recess (221) being flush with each other;
in step d), the at least one second opening (8020) includes three second openings (8020) and the metal mask (8) further has a first through hole (83) penetrating the metal mask (8) from an upper surface (82) of the metal mask (8) opposite to the lower surface (81) to the lower surface (81) of the metal mask (8), the first through hole (83) being in spatial communication with the first opening (8010) and extending from the first opening (8010) to a corresponding one of the peripheral surfaces (201) of the oscillating main body (2) to which the recess (221) is adjacent, the two protruding parts (222) of the one of the two side portions (22) respectively extending through two corresponding ones of the second openings (8020), the other one of the two side portions (22) extending through a remaining one of the second openings (8020); and
in step e), a top extending portion (32) of the top electrode layer (3) is formed in the first through hole (83) and extends from the top work portion (31) to the corresponding one of the peripheral surfaces (201) of the oscillating main body (2) to which the recess (221) is adjacent, at least one magnetic layer (5) including three magnetic layers (5) formed on the two protruding parts (222) of the one of the two side portions (22) and the other one of the two side portions (22), respectively.

8. The method as claimed in claim 7, wherein
in step a), a lower section (421) of a bottom extending portion (42) of the bottom electrode layer (4) is further formed to extend from the bottom work portion (41) to the corresponding one of the peripheral surfaces (201) of the oscillating main body (2) to which the recess (221) is adjacent;
in step d), the metal mask (8) further has a second through hole (84) which penetrates the metal mask (8) from the upper surface (82) of the metal mask (8) to the lower surface (81) of the metal mask (8), which is spaced apart from the first through hole (83), which extends to the corresponding one of the peripheral surfaces (201) of the oscillating main body (2) to which the recess (221) is adjacent, and which exposes the bottom surface (2211) of the recess (221); and
in step e), an upper section (423) of the bottom extending portion (42) is further formed on the bottom surface (2211) of the recess (221).

9. The method as claimed in claim 8, further comprising, after step e), forming an interconnecting section (422) of the bottom extending portion (42) on the corresponding one of the peripheral surfaces (201) of the oscillating main body (2) to interconnect the lower section (421) and the upper section (423).
